# EUROPEAN PATENT APPLICATION

(11) **EP 1 746 867 A1**
(43) Date of publication of application: **24.01.2007**
(21) Application number: 05739223.5
(22) Date of filing: 13.05.2005
(51) Int. Cl.: H05K 1/14

(54) **CONNECTOR EMPLOYING FLEXIBLE PRINTED BOARD**

(30) Priority: 14.05.2004 JP 2004144505
(71) Applicant: MATSUSHITA ELECTRIC INDUSTRIAL CO., LTD., Osaka 571-8501 (JP)
(72) Inventor: SUZUKI, Hiroyuki, c/o Matsushita Electric Ind., Osaka 540-6319 (JP); EMA, Tomiyo, c/o matsushita Electric Ind. Co., Ltd, Osaka 540-6319 (JP)
(74) Representative: Grünecker, Kinkeldey, Stockmair & Schwanhäusser Anwaltssozietät
(86) International application number: PCT/JP2005/008769
(87) International publication number: WO 2005/112527

(57) **Abstract**

To solve the problems that, when a flexible printed board used for modular parts or the like and another printed board are reconnected to each other, the flexible printed board is damaged upon stripping a connection part, removing an adhesive is difficult, and re-adhesion of the adhesive is difficult to obstruct easy reconnection.

A thermoplastic adhesive 8 is attached beforehand to a connection portion of a flexible printed board 9 for connection that connects a flexible printed board 6 to which an electronic part 4b or a liquid crystal 7 is connected and a printed board 1 on which an electronic component 4a is packed. With this structure, a reconnection work of the printed board 1 and the flexible printed board 6 is easily performed by replacing the flexible printed board 9 for connection.

## Description

### <Technical Field>

The present invention relates to a connection device for connecting a flexible printed board, which is used for modular parts, to another flexible printed board or a hard board.

### <Background Art>

In general, as a device for connecting a flexible printed board, which is used for modular parts, to another flexible printed board or a hard board, a method of connecting by using a connector has been widely used (for example, see Patent document 1). However, according to the method of connecting by using the connector, it is possible to easily exchange the board, but there is a limitation in reducing the thickness and weight.

In order to solve the problems, as a method of connecting without using the connector, a method of connecting the flexible printed board to another flexible printed board or the hard board by soldering or a method of connecting by using an adhesive of thermal compression bonding type has been used (for example, see Patent document 2 and Patent document 3).

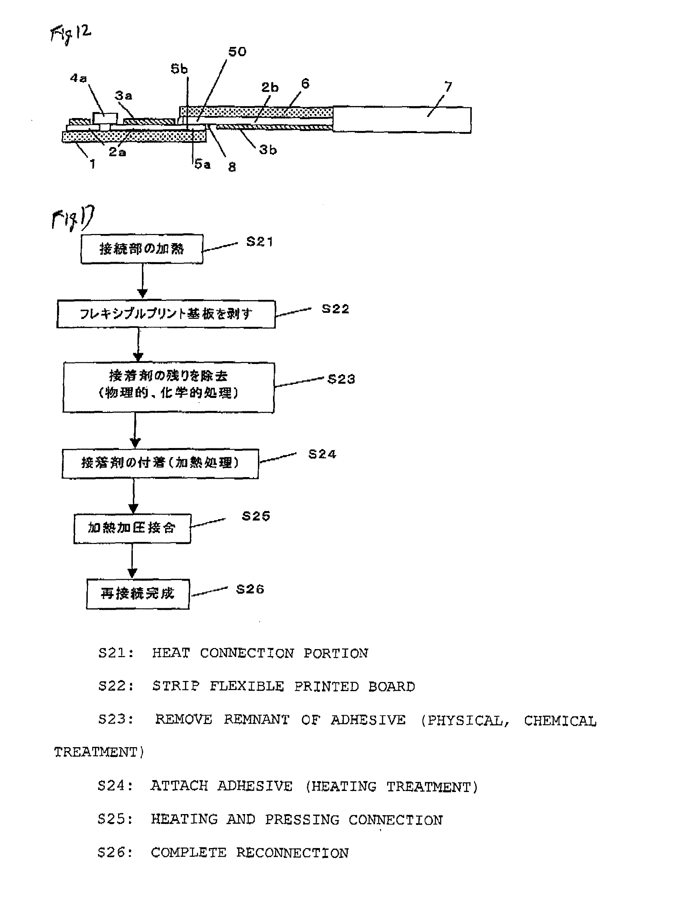

According to the method of connecting without using the connector, as shown in Fig. 12, a flexible printed board 6 used as an electronic part, such as a liquid crystal 7 module, is directly connected to a printed board 1 on which another electronic part 4a is packed by solder or by using an adhesive 8 of the thermal compression bonding type.

For this reason, if the connection of the flexible printed board 6 and the printed board 1 is not good, the flexible printed board 6 is stripped from the printed board 1, and then the flexible printed board 6 is reconnected to the printed board 1.

Fig. 13 shows procedure of the re-connection according to the related art. First, a connection portion to which the adhesive 8 is attached is heated by a hot plate or the like (step S21). The connection portion 50 is stripped by pushing the lower printed board 1 during the heated state and pulling out the upper flexible printed board 6 in a horizontal direction or an upward direction (step S22). The adhesive 8 remaining on the respective stripped boards is physically removed by a pincette or chemically removed by a solvent such as acetone (step S23). After the adhesive 8 is removed, new adhesive 8 is attached on the printed board 1 or the flexible printed board 6 and heated (step S24). The printed board 6 and the flexible printed board 1 are pressed against each other in the heated state of the adhesive 8 (step S25). The re-connection is completed by the above-mentioned procedures (step S26).
Patent document 1: JP-A-2003-133678 (fifth page, Fig. 9)
Patent document 2: JP-A-5-90725 (third page, Fig. 1)
Patent document 3: JP-A-61-22580 (second page, Fig. 1B)

According to the connection device of the related art, there are problems in that (1) the flexible printed board 6 is broken when the connection portion 50 is pulled out to be stripped; (2) it is difficult to remove the adhesive 8; and (3) it is hard to re-attach the new adhesive 8.

In addition, when the re-connection is performed, when the connection portion of the board is heated beforehand to attach the adhesive 8, if parts such as the liquid crystal 7 having weak heat resistance exist, the re-connection is required to be partially heated. Accordingly, since the distance between the connection portion and the parts having the weak heat resistance is narrow in the modular parts that are packed with high density, there are problems in that (4) it is difficult to partially heat; and (5) working efficiency becomes poor in the case where long periods of heating are required.

### <Disclosure of the Invention>

The invention has been made to solve the above-mentioned problems, and it is an object of the invention to provide a connection device of a flexible printed board that can be easily re-connected.

A connection device according to the invention has a structure that relays a flexible printed board and another printed board by using a flexible printed board for connection. With this structure, re-connection between the flexible printed board and the printed board can be easily performed by replacing the flexible printed board for connection that relays the flexible printed board and another printed board.

In addition, according to the connection device of the invention, a connection portion of the flexible printed board for connection may be provided with a thermoplastic adhesive. With this structure, since the flexible printed board may be re-connected to another printed board by heating the flexible printed board for connection, the flexible printed board for connection may be stripped more than the flexible printed board and the printed board without damaging parts, such as liquid crystal having weak heat resistance, that are provided on the flexible printed board and the printed board.

In addition, the connection device of the invention may have a structure in which a thermoplastic adhesive is provided on the connection portion of one side or both sides of the flexible printed board for connection. With this structure, after the flexible printed board for connection is stripped, the re-connection can easily be performed by replacing the flexible printed board for connection without removing the adhesive remaining on the flexible printed board and the another printed board and providing new adhesive.

In addition, the connection device according to the invention may employ a structure in which conductive particles are included in the thermoplastic adhesive.
With this structure, the height difference or the unevenness of the plating of the terminals of the flexible printed board for connection, the flexible printed board, and another printed board may be assimilated. Therefore, it may be possible to improve stability of the electric connection.

In addition, according to the connection device of the invention, projections may be provided on the terminal of one side or both sides of the flexible printed board for connection that relays between the flexible printed board and another printed board. With this structure, the tips of the projections break through the adhesive that is provided between the terminals facing each other, and the projections are connected to the terminal of the flexible printed board and the terminal of the printed board. Therefore, it may be possible to improve stability of the electric connection.

According to the invention, since the flexible printed board that is used for modular parts is connected to another flexible printed board or the hard board by the flexible printed board for connection in which the thermoplastic adhesive is provided beforehand on the connection portion of one side or both sides thereof, the re-connection can be easily performed. In addition, since the flexible printed board for connection that relays the flexible printed board and another printed board is provided, there has the effect that the electronic parts such as a liquid module provided on the flexible printed board or the hard board are easily re-connected without distorting or being damaged by heat or the like.

### <Brief Description of the Drawings>

Fig. 1A is a cross sectional view showing a state prior to connection of a connection device according to a first embodiment of the invention, Fig. 1B is a cross sectional view showing a connection state of a connection device according to a first embodiment of the invention, and Fig. 1C is a partial sectional view showing a connection device according to a first embodiment of the invention.
Fig. 2 is an outline view showing a flexible printed board for connection according to a first embodiment of the invention.
Fig. 3 is a flow chart showing a re-connection method of a connection device according to the invention.
Fig. 4A is a cross sectional view showing a connection device according to a second embodiment of the invention, and Fig. 4B is a partial sectional view showing a connection device according to a second embodiment of the invention.
Fig. 5A is a cross sectional view, showing a connection device according to a third embodiment of the invention, and Fig. 5B is a partial sectional view showing a connection device according to a third embodiment of the invention.
Fig. 6 is an outline view showing a flexible printed board for connection according to a third embodiment of the invention.
Fig. 7A is a cross sectional view showing a connection device according to a fourth embodiment of the invention, and Fig. 7B is a partial sectional view showing a connection device according to a fourth embodiment of the invention.
Fig. 8A is a cross sectional view showing a connection device according to a fifth embodiment of the invention, and Fig. 8B is a partial sectional view showing a connection device according to a fifth embodiment of the invention.
Fig. 9A is a cross sectional view showing a connection device according to a sixth embodiment of the invention, and Fig. 9B is a partial sectional view showing a connection device according to a sixth embodiment of the invention.
Fig. 10A is a cross sectional view showing a connection device according to a seventh embodiment of the invention, and Fig. 10B is a partial sectional view showing a connection device according to a seventh embodiment of the invention.
Fig. 11A is a cross sectional view showing a connection device according to an eighth embodiment of the invention, and Fig. 11B is a partial sectional view showing a connection device according to an eighth embodiment of the invention.
Fig. 12 is a cross sectional view showing the related art connection device.
Fig. 13 is a flow chart showing a connection method of the related art connection device.

### <Reference Numerals>

- 1: printed board
- 2a, 2b, 2c, 2d: conductor
- 3a, 3b, 3c: resist
- 4a, 4b: electronic part
- 5a, 5b, 5c, 5d, 5e, 5f: terminal
- 50: connection portion
- 6: flexible printed board
- 7: liquid crystal
- 8: adhesive
- 9, 12: flexible printed board for connection
- 10: conductive particles
- 11: projections

### <Best Mode for Carrying Out the Invention>

Hereinafter, preferred embodiments of the invention will be described with reference to the accompanying drawings.

### (First Embodiment)

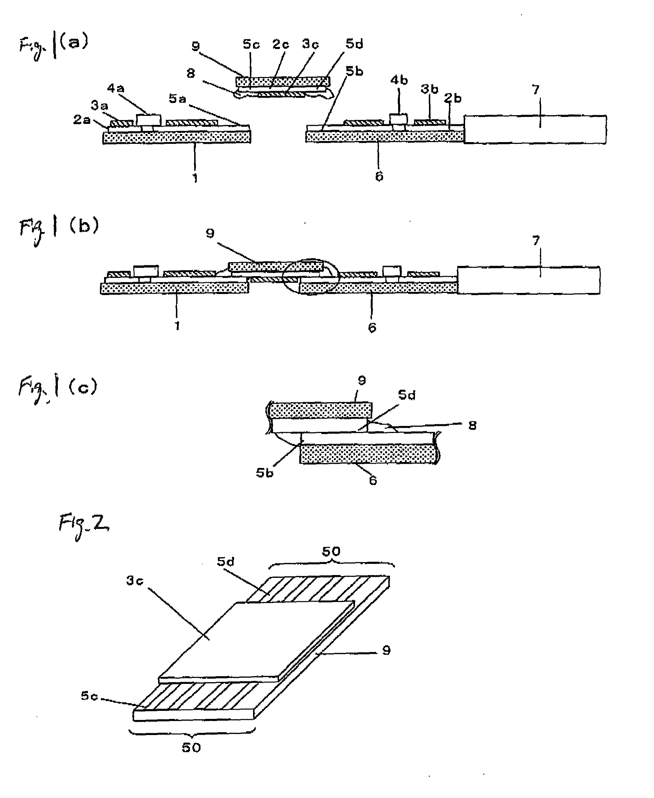

Fig. 1 is a cross sectional view of a connection device according to a first embodiment of the invention. The same reference numerals can be denoted to the same components as in the comparative example and the description thereof will be omitted. Fig. 1A is a cross sectional view showing a state before a printed board 1 is connected to a flexible printed board 6 by a flexible printed board 9 for connection. Fig. 1B is a cross sectional view showing a state in which the printed board 1 is connected to the flexible printed board 6 by the flexible printed board 9 for connection, and Fig. 1C is a partially enlarged sectional view of a connection portion of Fig. 1B. Fig. 2 is an outline view of terminals 5c and 5d of the flexible printed board 9 for connection, as can be seen from the upper side.

As shown in Fig. 1A, the printed board 1 has a conductor 2a on the surface thereof. The conductor 2a forms a circuit pattern, and a terminal 5a is provided at one end of the conductor 2a. An electronic part 4a is disposed on the printed board 1 so as to be electrically connected to the conductor 2a. A resist 3a is provided in a region except for the terminal 5a and the electronic part 4a of the printed board 1, thereby preventing an electrical short between the terminal 5a and the electronic part 4a.

The flexible printed board 6 is a part of a liquid crystal 7 module. The flexible printed board 6 has a conductor 2b on the surface thereof. The conductor 2b forms the circuit pattern, and a terminal 5b is provided at one end of the conductor 2b. An electronic part 4b is disposed on the flexible printed board 6 so as to be electrically connected to the conductor 2b. A resist 3b is provided in the region except for the terminal 5b and the electronic part 4b of the flexible printed board 6, thereby preventing an electrical short between the terminal 5b and the electronic part 4b.

The flexible printed board 9 for connection has a conductor 2c on one side thereof. The conductor 2c forms the circuit pattern, and terminals 5c and 5d are provided at both ends of the conductor 2c. A resist 3c is provided in the region except for the terminals 5c and 5d of the flexible printed board 9 for connection, thereby preventing an electrical short between the terminals 5c and 5d. A thermoplastic adhesive 8 is attached to a connection portion 50 including the terminals 5c and 5d in advance.

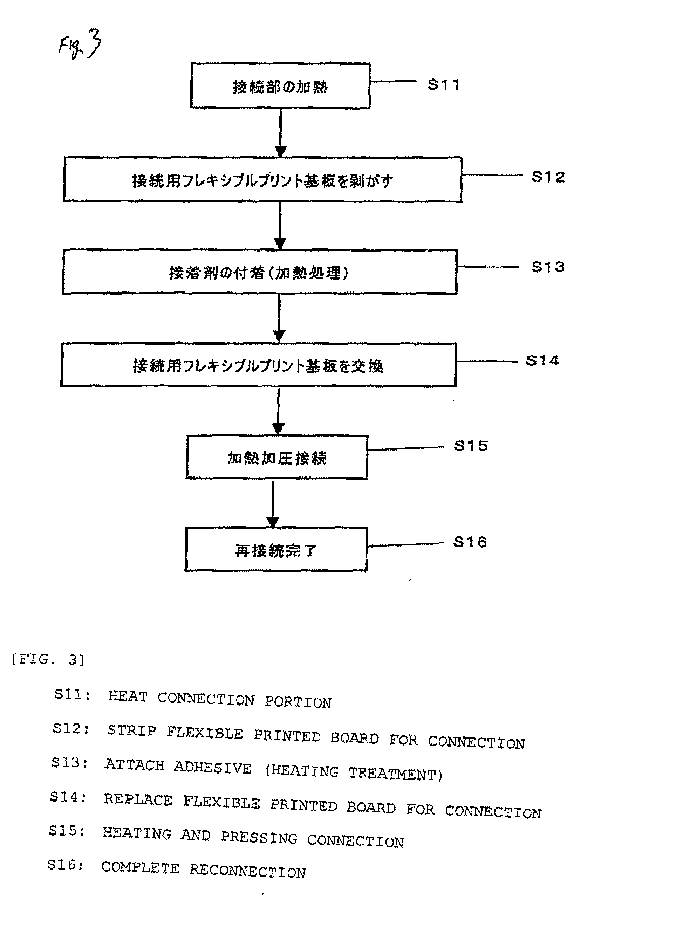

Fig. 3 is a flow chart of the re-connection method according to the invention. First, the connection portion 50 of the flexible printed board 9 for connection is heated by a hot plate or the like (step S11), and the flexible printed board 9 for connection is stripped from the printed board 1 and the flexible printed board 6 by pulling out the upper flexible printed board 9 for connection in a horizontal direction or an upward direction during a heated state (step S12). After the flexible printed board 9 for connection is removed, the adhesive 8 is attached to the new flexible printed board 9 for connection and heated if necessary (step S13). The stripped flexible printed board 6 is replaced by the flexible printed board 9 for connection to which the adhesive is attached (step S14), the new flexible printed board 9 for connection to which the adhesive is attached is connected to the flexible printed board 6 and the printed board 1 by heating and pressing (step S15), thereby completing the re-connection (step S16). At this time, since the adhesive is attached beforehand to the replaced flexible printed board 9 for connection, it is not required to remove the remnant of the old adhesive as in the comparative example. Therefore, it is not required to attach the new adhesive 8 to the printed board 1 and the flexible printed board 6.

According to the first embodiment of the invention, since the connection portion 50 is stripped while the flexible printed board 9 for connection, it may prevent the printed board 1 and the flexible printed board 6 from being damaged. In addition, according to the invention, since the adhesive may be attached beforehand to the new flexible printed board 9 for connection, it is not required to perform the removal of the adhesive 8 from the printed board 1 and the flexible printed board 6 or the reattachment of the adhesive 8 to the printed board 1 and the flexible printed board 6 after the removal. Therefore, the re-connection operation may be performed.

In addition, the printed board 1 may be any one of the flexible printed board, the hard board or the like. Furthermore, the liquid crystal 7 may be another electronic part such as a speaker.

### (Second Embodiment)

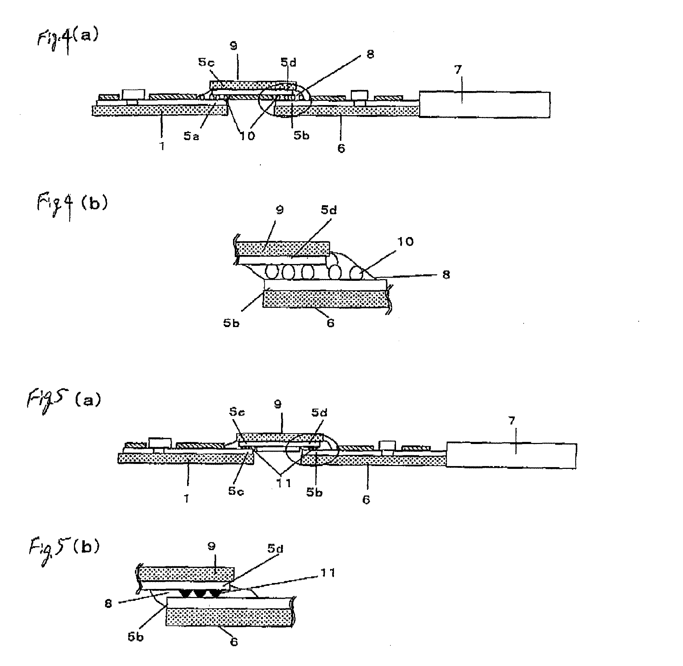

Next, a connection device using a flexible printed board according to a second embodiment of the invention will be described. Fig. 4 is a cross sectional view of the connection device according to the second embodiment. Fig. 4A is a cross sectional view showing a state in which the printed board 1 is connected to the flexible printed board 6 by the flexible printed board 9 for connection, and Fig. 4B is a partially enlarged sectional view of a connection portion of Fig. 4A. The adhesive 8 used to connect the printed board 1, the flexible printed board 6, and the flexible printed board 9 for connection includes conductive particles 10 in Fig. 4. Other structures and the re-connection method are equal to the first embodiment.

According to the second embodiment of the invention, the re-connection may be easily performed as in the first embodiment. In addition, since the conductive particles 10 included in the adhesive 8 allow a terminal 5a to electrically connect to a terminal 5c, and a terminal 5b to electrically connect to a terminal 5d, height difference of the terminals 5a and 5b or unevenness of the plating may be assimilated. Therefore, it may be possible to improve stability of the electric connection after the connection.

### (Third Embodiment)

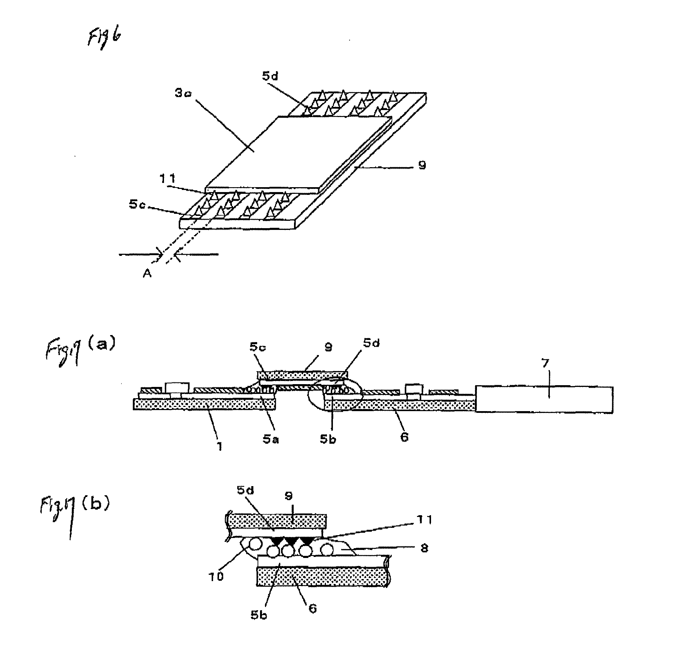

Next, a connection device using a flexible printed board according to a third embodiment of the invention will be described. Fig. 5 is a cross sectional view of the connection device according to the third embodiment. Fig. 5A is a cross sectional view showing a state in which the printed board 1 is connected to the flexible printed board 6 by the flexible printed board 9 for connection, and Fig. 5B is a partially enlarged sectional view of a connection portion of Fig. 5A. Projections 11 are provided on the terminals 5c and 5d of the flexible printed board 9 for connection in Fig. 5. The projections 11 are chemically processed by plating and etching. Other structures and the re-connection method are equal to the first embodiment.

According to the third embodiment of the invention, the re-connection may be easily performed as in the first embodiment. In addition, since the projections 11 break through the adhesive 8 that is provided between the terminals 5a and 5c, and the terminals 5b and 5d, and the projections 11 are connected to the terminals 5a and 5b, it may be possible to improve stability of the electric connection.

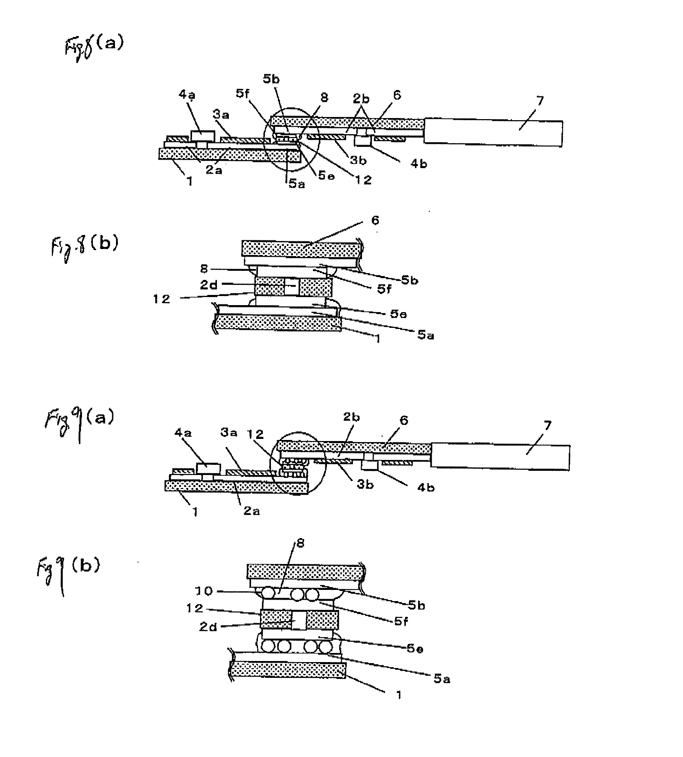

Fig. 6 is an outline view of the terminals 5c and 5d of the flexible printed board 9 for connection, as can be seen from the upper side. According to the third embodiment of the invention, the conductive particles 10 are not included in the adhesive 8. In addition, since wiring of the terminals 5c and 5d and the gap A for wiring can be decreased, the width of the flexible printed board 9 for connection may be reduced. Furthermore, the projections 11 may be worked by a physical process such as a molding as well as a chemical process.

### (Fourth Embodiment)

Next, a connection device using a flexible printed board according to a fourth embodiment of the invention will be described. Fig. 7 is a cross sectional view of the connection device according to the fourth embodiment. Fig. 7A is a cross sectional view showing a state in which the printed board 1 is connected to the flexible printed board 6 by the flexible printed board 9 for connection, and Fig. 7B is a partially enlarged sectional view of a connection portion of Fig. 7A. The projections 11 are provided on the terminals 5c and 5d of one surface of the flexible printed board 9 for connection in Fig. 7. The conductive particles 10 are included in the adhesive 8 used for the connection. Other structures and the reconnection method are equal to the first embodiment.

According to the fourth embodiment of the invention, the re-connection may be easily performed as in the first embodiment. In addition, since the projections 11 break through the adhesive 8 that is provided between the terminals 5a and 5c, and the terminals 5b and 5d, it may be possible to improve stability of the electric connection. Furthermore, since the conductive particles 10 included in the adhesive 8 allow a terminal 5a to electrically connect to a terminal 5c, and a terminal 5b to electrically connect to a terminal 5d, the height difference or the unevenness of the plating of the terminals 5a and 5b may be assimilated. Therefore, it may be possible to improve stability of the electric connection after the connection.

### (Fifth Embodiment)

Next, a connection device using a flexible printed board according to a fifth embodiment of the invention will be described. Fig. 8 is a cross sectional view of the connection device according to the fifth embodiment. Fig. 8A is a cross sectional view showing a state in which the printed board 1 is connected to the flexible printed board 6 by the flexible printed board 12 for connection, and Fig. 8B is a partially enlarged sectional view of a connection portion of Fig. 8A. The flexible printed board 12 for connection that connects the printed board 1 and the flexible printed board 6 is a double-sided wiring board, the terminals 5e and 5f are provided at both sides of the flexible printed board 12 for connection in Fig. 8. The terminals 5e and 5f are electrically connected to each other by filling a conductor 2d into a hole that is perforated through the flexible printed board 12 for connection. Other structures and the re-connection method are equal to the first embodiment.

According to the fifth embodiment of the invention, by stripping the flexible printed board 12 for connection, the re-connection may be easily performed as in the first embodiment. If the printed board 1 is the hard board, the flexible printed board 12 for connection becomes damaged first. Therefore, it may prevent the damage of the flexible printed board 6. In addition, it may reduce the area required for the connection as compared to the first embodiment by providing beforehand the thermoplastic adhesive 8 on the terminals 5e and 5f on both sides of the flexible printed board 12 for connection.

In addition, the flexible printed board 12 for connection having the terminals 5e and 5f on both sides thereof may be configured such that the terminals are provided on both sides by bending one-sided wiring board, and may be a multi-layered wiring board.

### (Sixth Embodiment)

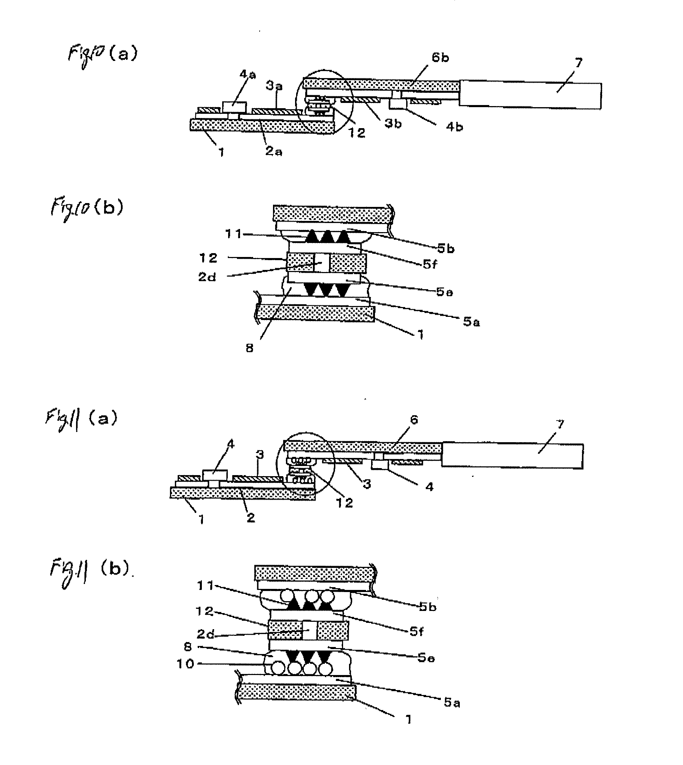

Next, a connection device using a flexible printed board according to a sixth embodiment of the invention will be described. Fig. 9 is a cross sectional view of the connection device according to the sixth embodiment. Fig. 9A is a cross sectional view showing a state in which the printed board 1 is connected to the flexible printed board 6 by the flexible printed board 12 for connection, and Fig. 9B is a partially enlarged sectional view of a connection portion of Fig. 9A. The conductive particles 10 are included in the adhesive 8 for the connection in Fig. 9. Other structures and the re-connection method are equal to the fifth embodiment.

According to the sixth embodiment of the invention, the re-connection may be easily performed as in the first embodiment. In addition, as in the second embodiment, since the height difference or the unevenness of the plating of the terminals 5a and 5b may be assimilated, it may be possible to improve stability of the electric connection after the connection. In addition, as in the fifth embodiment, since the flexible printed board 12 for connection has the terminals 5e and 5f on both sides thereof, it may reduce the area required for the connection as compared to the second embodiment.

### (Seventh Embodiment)

Next, a connection device using a flexible printed board according to a seventh embodiment of the invention will be described. Fig. 10 is a cross sectional view of the connection device according to the seventh embodiment. Fig, 10A is a cross sectional view showing a state in which the printed board 1 is connected to the flexible printed board 6 by the flexible printed board 12 for connection, and Fig. 10B is a partially enlarged sectional view of a connection portion of Fig. 10A. The projections 11 are provided on the terminals 5e and 5f on both sides of the flexible printed board 12 for connection in Fig. 10. Other structures and the re-connection method are equal to the fifth embodiment.

According to the seventh embodiment of the invention, the re-connection may be easily performed as in the first embodiment. In addition, as in the third embodiment, since the projections 11 break through the adhesive 8 and the projections 11 are connected to the terminals 5a and 5b, it may be possible to improve stability of the electric connection. Furthermore, since the adhesive 8 does not use the conductive particles, the wiring of the terminals 5e and 5f and the gap between the wirings can be decreased. For this reason, the width of the flexible printed board 12 for connection may be reduced. In addition, as in the fifth embodiment, since the flexible printed board 12 for connection has the terminals 5e and 5f on both sides thereof, it may reduce the area required for the connection as compared to the connection device of the third embodiment.

### (Eighth Embodiment)

Next, a connection device using a flexible printed board according to an eighth embodiment of the invention will be described. Fig. 11 is a cross sectional view of the connection device according to the eighth embodiment. The projections 11 are provided on the terminals 5e and 5f on both sides of the flexible printed board 12 for connection in Fig. 11, and the adhesive 8 includes the conductive particles 10. Other structures and the reconnection method are equal to the fifth embodiment.

According to the eighth embodiment of the invention, the re-connection may be easily performed as in the first embodiment. In addition, as in the fourth embodiment, since the projections 11 break through the adhesive 8, it may be possible to improve stability of the electric connection. Furthermore, since the conductive particles 10 included in the adhesive 8 allow a terminal 5a to electrically connect to a terminal 5e, and a terminal 5b to electrically connect to a terminal 5f, the height difference or the unevenness of the plating of the terminals 5a and 5b may be assimilated. Therefore, it may be possible to improve stability of the electric connection after the connection. Since the flexible printed board 12 for connection has the terminals 5e and 5f on both sides thereof, it may reduce the area required for the connection as compared to the connection device of the fourth embodiment.

Although the present invention has been described in connection with the exemplary embodiments of the invention, it will be apparent to those skilled in the art that various modifications and changes may be thereto without departing from the scope and spirit of the invention.

This application claims priority from Japanese Patent Application No. 2004-144505 filed on May 14, 2004 in the Japanese Intellectual Property Office, the disclosure of which is incorporated therein by reference in its entirety.

### <Industrial Applicability>

According to the invention, the connection device using the flexible printed board can easily perform the re-connection of the flexible printed board and the printed board. Therefore, it can be applied to electronic appliances such as portable appliances that perform high-density packaging by using the flexible printed board.

## Claims

1. A connection device that connects a flexible printed board and another printed board, the device comprising:
a flexible printed board for connection that is used as a relay unit between the flexible printed board and the another printed board.

2. The connection device according to claim 1,
wherein the flexible printed board for connection and the flexible printed board, and the flexible printed board for connection and the another printed board are connected by a thermoplastic adhesive, respectively.

3. The connection device according to claim 2,
wherein the thermoplastic adhesive is attached to a connection portion of one side or both sides of the flexible printed board for connection.

4. The connection device according to claim 2 or 3,
wherein the adhesive includes conductive particles.

5. The connection device according to any one of claims 2 to 4,
wherein projections are provided on a terminal of one side or both sides of the flexible printed board for connection.
